# EUROPEAN PATENT APPLICATION

(11) **EP 4 421 867 A1**
(43) Date of publication of application: **28.08.2024**
(21) Application number: 23203420.7
(22) Date of filing: 13.10.2023
(51) Int. Cl.: H01L 23/552, H01L 23/14, H01L 23/498

(54) **MAGNETIC SHIELDS FOR INTEGRATED CIRCUITS**

(30) Priority: 27.02.2023 US 202318175475
(71) Applicant: GLOBALFOUNDRIES Singapore Pte. Ltd., Singapore 738406 (SG)
(72) Inventor: Naik, Vinayak Bharat, 738406 Singapore (SG); Dixit, Hemant, Malta, NY 12020 (US); Syed Mohammed, Zishan Ali, 738406 Singapore (SG)
(74) Representative: Grünecker Patent- und Rechtsanwälte PartG mbB

(57) **Abstract**

A shield structure for a semiconductor chip comprises a chip mounting region on a base plate and a shell connected to the base plate. The shell is arranged over the base plate to provide a chamber having a volume, and the chip mounting region is arranged within the volume.

## Description

### FIELD OF THE INVENTION

The disclosed embodiments relate generally to magnetic shields, and more particularly, to magnetic shields for integrated circuits.

### BACKGROUND

Integrated circuit chips, for example, magnetic random-access memory (MRAM) chips, are typically encapsulated in packages that provide an electrical connection to a printed circuit board. MRAM chips may include a free layer and a reference layer. The magnetization direction of the free layer can be switched relative to the magnetization direction of the reference layer to high and low resistance states, representing different data bits. However, an external magnetic field may switch or disturb the free layer, leading to the potential malfunctioning of the MRAM chip. There is therefore a need to provide some form of shielding for the MRAM chip against external magnetic fields, to avoid such disturbances to the MRAM chip function.

Current magnetic shields suffer from low shielding efficiency and do not provide sufficient shielding from external magnetic fields. There is therefore a continued need to provide improved shielding solutions to overcome the challenges mentioned above.

### SUMMARY

In an aspect of the present disclosure, a shield structure for a semiconductor chip comprises a chip mounting region on a base plate and a shell arranged over the base plate to provide a chamber having a volume within which the chip mounting region is arranged. The shell is connected to the base plate.

In another aspect of the present disclosure, a magnetic shield structure for a semiconductor chip comprises a chip mounting region on a base plate and a shell arranged over the base plate to provide a chamber having a volume within which the chip mounting region is arranged. The shell comprises a magnetic material.

### BRIEF DESCRIPTION OF THE DRAWINGS

The disclosed embodiments will be better understood from a reading of the following detailed description, taken in conjunction with the accompanying drawings:
FIG. 1A shows a perspective view of a shield structure 100 for a semiconductor chip, according to an embodiment of the disclosure.
FIG. 1B shows a corresponding cross-sectional view of the shield structure 100 for the semiconductor chip taken along section line X-X' shown in FIG. 1A, according to an embodiment of the disclosure.
FIG. 2A shows a perspective view of a shield structure 200 for a semiconductor chip, according to another embodiment of the disclosure.
FIG. 2B shows a corresponding cross-sectional view of the shield structure 200 for the semiconductor chip taken along section line Y-Y' shown in FIG. 2A, according to another embodiment of the disclosure.

For simplicity and clarity of illustration, the drawings illustrate the general manner of construction, and certain descriptions and details of well-known features and techniques may be omitted to avoid unnecessarily obscuring the discussion of the described embodiments of the devices. Additionally, elements in the drawings are not necessarily drawn to scale. For example, the dimensions of some of the elements in the drawings may be exaggerated relative to other elements to help improve the understanding of embodiments of the devices. The same reference numerals in different drawings denote the same elements, while similar reference numerals may, but do not necessarily, denote similar elements.

### DETAILED DESCRIPTION

The following detailed description is exemplary in nature and is not intended to limit the devices or the application and uses of the devices. Furthermore, there is no intention to be bound by any theory presented in the preceding background of the devices or the following detailed description.

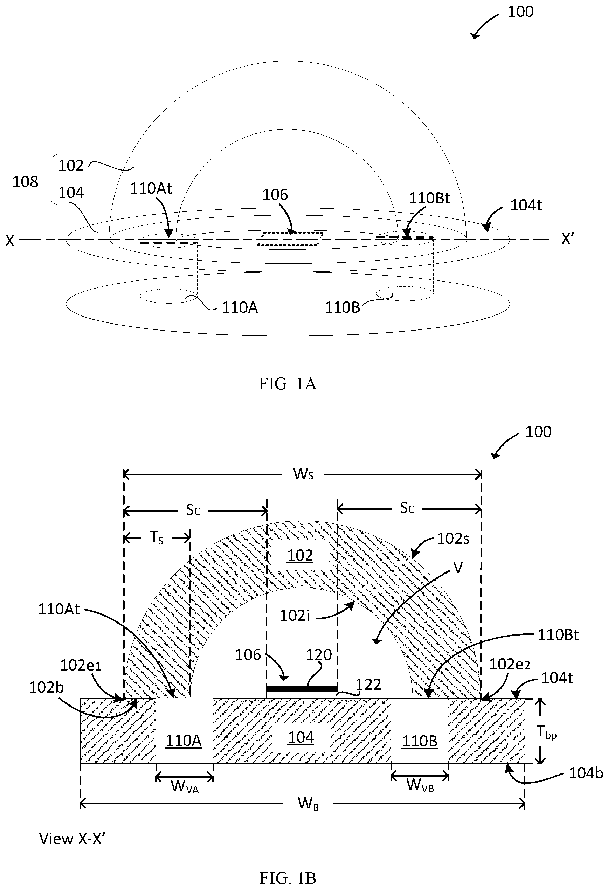

FIG. 1A shows a perspective view of a shield structure 100 for a semiconductor chip, according to an embodiment of the disclosure. The shield structure 100 may include a magnetic shield 108 having a shell 102 on a base plate 104. The shell 102 may be connected or magnetically coupled to the base plate 104 such that magnetic field lines may pass from the shell 102 to the base plate 104 or vice versa. In some embodiments, the shell 102 may be a separately formed structure from base plate 104 but may directly contact the base plate 104 to allow the magnetic coupling. In other embodiments, the shell 102 may be integrally formed with base plate 104 as a single integral structure. The shield structure 100 includes a chip mounting region 106 within which an integrated circuit chip 120 (not shown) may be arranged. The chip mounting region 106 may be arranged on the base plate 104 and within the base plate region that is under the shell 102. The chip mounting region 106 may be arranged such that it is within a central region of the base plate under the shell 102. For example, the chip mounting region 106 may be laterally spaced from the shell 102 on at least two opposing sides by substantially the same distance Sc. An integrated circuit chip 120, such as a MRAM chip, may be placed within the chip mounting region 106 to be shielded from undesired external fields, such as magnetic fields.

Now referring to FIG. 1B which shows a corresponding cross-sectional view of the shield structure 100 for a semiconductor chip taken along section line X-X' shown in FIG. 1A, according to an embodiment of the disclosure. The shell 102 is arranged over the base plate 104 to provide a chamber having a volume V, within which the chip mounting region 106 is arranged. The base plate 104 may have a thickness Tbp, measured from the top surface 104t to the bottom surface 104b. In an embodiment, the thickness Tbp may be within the range of 10 micrometers (µm) to 1 millimeter (mm). The top surface 104t of the base plate 104 faces the shell 102 of the magnetic shield 108 and may be at least partially under and covered by the shell 102. The top surface 104t may include the chip mounting region 106. A circuit chip 120 may be arranged within the chip mounting region 106 and may be secured by a suitable adhesive 122, such as a die attach epoxy, as an example. In an embodiment, the chip mounting region 106 may be at a lower vertical level than the top surface 104t of the base plate 104, for example, chip mounting region 106 may be located in an indented region below the top surface 104t. In another embodiment, the chip mounting region 106 may be elevated from the top surface 104t, for example, the chip mounting region 106 may be arranged on a raised platform above top surface 104t. In yet another embodiment, the chip mounting region 106 may be at the same level as top surface 104t, for example, substantially coplanar with top surface 104t. The base plate 104 may have shape suited for the intended applications, for example, a circular or polygonal shape. It may be understood that top surface 104t of the base plate 104 may have a profile corresponding to the shape of the base plate.

Still referring to FIG. 1B, the base plate 104 may have a width W_{B} measured along the top surface 104t, from an edge to an opposite edge of the base plate. The shell 102 may have a width Ws, measured from an outermost bottom edge 102ei to another outermost bottom edge 102e₂ on the opposite end of the shell. The outermost bottom edges 102ei and 102e₂ may be on or directly contacting the top surface 104t of the base plate 104. The shell 102 may include an outer shell surface 102s and an inner shell surface 102i opposite the outer shell surface 102s. The shell 102 further includes a bottom shell surface 102b adjoining the outer shell surface 102s and the inner shell surface 102i. The bottom shell surface 102b may at least partially contact the top surface 104t of the base plate 104. The inner shell surface 102i of the shell 102 may be facing the top surface 104t of the base plate 104 and may be arranged over and spaced from the chip mounting region 106. The thickness Ts of the shell 102 may be measured from a point on the outer shell surface 102s to an opposite point on the inner shell surface 102i. For example, the thickness Ts of the shell 102 may be taken from a point on the outermost bottom edge 102ei to an opposite point on the inner shell surface 102i. In an embodiment, the thickness Ts may be within the range of 10 micrometers (µm) to 1 millimeter (mm). In some embodiments, the outer shell surface 102s of the shell 102 may have a curved profile. For example, the shell 102 may include a domed portion. For example, the shell 102 may include a hemispherical portion. In some embodiments, the shell 102 may further include a cylindrical wall (not shown) extending below the hemispherical portion, where the cylindrical wall is in direct contact with the top surface 104t of the base plate 104. In some embodiments, the inner shell surface 102i may also have a curved profile similar to the outer shell surface 102s. In other embodiments, the inner shell surface 102i may have an angular profile instead, for example, adjoining linear surfaces.

The volume V of the chamber as aforementioned may be bounded by the inner shell surface 102i and at least a portion of the top surface 104t of the base plate 104. In some embodiments, the width W_{B} of the base plate 104 may be substantially equal to the width of the shell 102, while in other embodiments, the width W_{B} may be different from the width Ws. For example, the width W_{B} of the base plate 104 may be larger than the width Ws of the shell 102.

The magnetic shield 108 may also include vias 110A and 110B in the base plate 104, with the vias being spaced apart from each other. The vias 110A and 110B may extend from a top surface 104t to a bottom surface 104b of the base plate 104 and may be arranged at least partially below the shell 102. Vias 110A and 110B may each have at least a portion that directly contacts the bottom shell surface 102b of the shell 102. The vias 110A and 110B may each have a top surface 1 10At and 1 10Bt respectively, and the top surfaces 1 10At and 1 10Bt may at least partially overlap with and directly contact the bottom shell surface 102b of the shell 102. In an embodiment, both or one of the top surfaces 1 10At and 1 10Bt may fully overlap with and directly contact the bottom shell surface 102b of the shell 102. In another embodiment, for at least one via, a portion of the top surface of the via may be covered by and directly contact the bottom shell surface 102b of the shell 102, while another portion of the top surface of the same via may be uncovered by the bottom shell surface 102b. For example, a portion of top surface 1 10At may be covered by and directly contact the bottom shell surface 102b of the shell 102, while another portion of top surface 1 10At may be uncovered by the bottom shell surface 102b of the shell 102. The shape of each of the top surfaces 1 10At and 1 10Bt may be circular, elliptical, polygonal, or any other shapes as required by the device design. The vias 110A and 110B may have widths W_{VA} and W_{VB} respectively. In some embodiments, the widths W_{VA} and W_{VB} may be less than 1 millimeter (mm). In an embodiment, the widths W_{VA} and Wvs may be substantially the same. In another embodiment, the widths W_{VA} and Wvs may be different. In an embodiment, the widths of the vias 110A and 110B may be at least as wide as the thickness T_{S} of the shell 102. For example, the width W_{VA} may be larger than the thickness T_{S}. In some embodiments, the vias 110A and 110B may be filled with a non-magnetic material, for example, copper, aluminum, or a non-metallic material. In some embodiments, the vias 110A and 110B may be left unfilled, for example, having air within the vias. The vias 110A and 110B may provide high reluctance paths for magnetic field lines from an external magnetic field.

The shell 102 and the base plate 104 of the magnetic shield 108 may be made of a suitable magnetic material comprising, for example, iron, nickel, cobalt, or alloys thereof. In an embodiment, the shell 102 and the base plate 104 may be made of the same magnetic materials. In another embodiment, the shell 102 and the base plate 104 may be made of different magnetic materials. For example, the shell 102 may be made of a magnetic material having a lower magnetic permeability than the base plate 104. In use, the shell 102 may provide magnetic shielding for the enclosed chip, while the base plate 104 may be a magnetic ground plane.

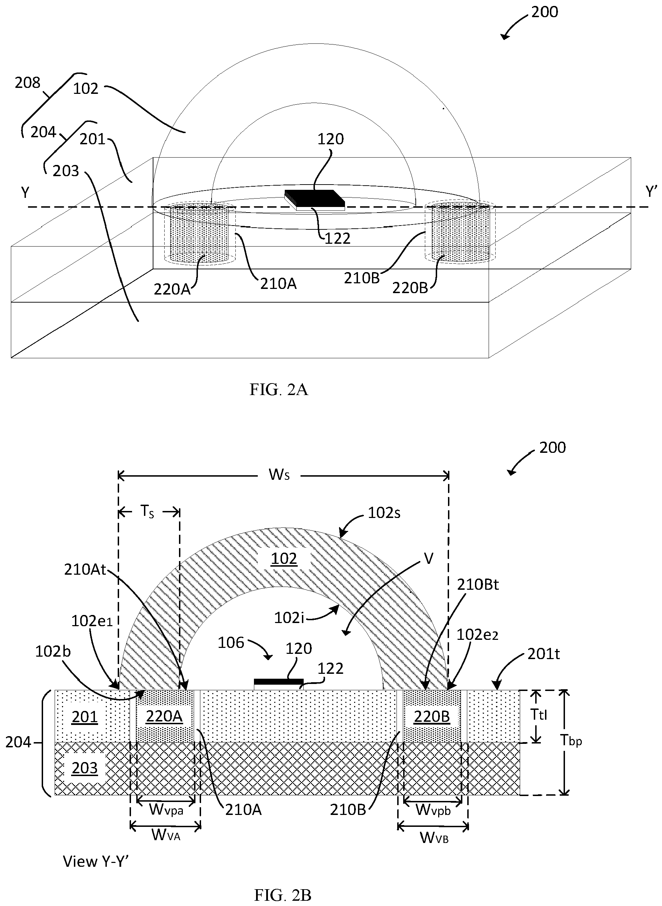

The embodiments shown in FIG. 1A may be modified to form alternative embodiments without departing from the scope of the disclosure. For example, FIG. 2A shows a perspective view of a shield structure 200 for a semiconductor chip, according to another embodiment of the disclosure. Like features in FIG. 1A may be indicated by like numerals in FIG. 2A. The base plate 204 may be a multi-layer plate and may include a top layer 201 over a bottom layer 203. The top layer 201 may space the shell 102 from the bottom layer 203. The base plate 204 may further include vias 210A and 210B in the top layer 201, and via plugs 220A and 220B within vias 210A and 210B, respectively. The top layer 201 may be made of a non-magnetic material, while the bottom layer may be made of a magnetic material. In an embodiment, the top layer 201 may be made of plastic, ceramic or a suitable semiconductor material, such as silicon, germanium, gallium arsenide, silicon carbide, gallium nitride as non-limiting examples. The bottom layer 203 and the via plugs 220A and 220B may include a suitable magnetic material, for example, iron, nickel, cobalt, or alloys thereof. In some embodiments, the bottom layer 203 and the via plugs 220A and 220B may comprise the same magnetic material. In other embodiments, the bottom layer 203 and via plugs 220A and 220B may comprise different magnetic materials.

Now referring to FIG. 2B which shows a corresponding cross-sectional view of the shield structure 200 shown in FIG. 2A, taken along line Y-Y'. The vias 210A and 210B may extend from the top surface 201t of the top layer 201 to the top surface of the bottom layer 203. The via plugs 220A and 220B may extend from the bottom shell surface 102b of the shell 102 to the top surface of the bottom layer 203. The width Wvpa of plug 220A may be smaller than or substantially the same as the width W_{VA} of via 210A. Similarly, the width Wvpb of plug 220B may be smaller than or substantially the same as the width W_{VB} of via 210B. In an embodiment, the widths of the via plugs 220A and 220B may be at least the thickness T_{S} of the shell 102. In some embodiments, the widths Wvpa and Wvpb may be less than 1 millimeter (mm). The vias 210A and 210B may have top surfaces 210At and 210Bt, respectively, which may be in direct contact with the bottom shell surface 102b of the shell 102. Top surfaces 210At and 210Bt may each have a shape that is circular, elliptical, polygonal or any other shapes as required by the device design. The via plugs 220A and 220B may magnetically couple the shell 102 and the bottom layer 203 such that an external magnetic field incident on the shell 102 may travel through the via plugs 220A and 220B to the bottom layer 203.

In an embodiment, the shield structure 100 shown in FIGS. 1A and 1B may be formed by separately forming the shell 102 and base plate 104, and thereafter assembling the shell 102 and base plate 104 together after placing the chip within the chip mounting region 106. For example, the base plate 104 may be formed by pressing or stamping the desired base plate shapes from a suitably thin layer of a selected magnetic material. Alternatively, the base plate 104 may be formed by depositing a layer of magnetic material over a substrate by a suitable deposition process, for example, physical vapor deposition or any other suitable deposition process. Vias 110A and 110B may be etched, drilled, or punched in the base plate 104. An integrated circuit chip 120 may be attached to the base plate 104 by a pick-and-place method or any other suitable assembly method as appropriate.

The shell 102 of the magnetic shield 108 may similarly be formed by pressing or stamping a layer of a suitable magnetic material between two dies. In an embodiment, the shell 102 may be individually placed over the base plate 104 holding the integrated circuit chip 120. In another embodiment, the shell 102 may be part of an array of shells 102 which has been designed to align with and be placed over an array of base plates 104. A suitable bonding process, for example, soldering, may be used to secure the shell 102 to the base plate 104.

The shell 102 of shield structure 200 as shown in FIGS. 2A and 2B may be formed in a similar manner as described above. In an embodiment, the base plate 204 may be formed by bonding, laminating or depositing the top layer 201 over the bottom layer 203. Vias 210A and 210B may be formed in the base plate 204 by etching, laser cutting, drilling, or any method suited to the chosen materials for top layer 201 and bottom layer 203. In another embodiment, vias 210A and 210B may first be formed in the top layer 201 before bonding or laminating the top layer 201 to the bottom layer 203. In some embodiments, via plugs 220A and 220B may be formed by filling up the vias 210A and 210B with a selected magnetic material, for example, by a suitable deposition method. In other embodiments, via plugs 220A and 220B may be formed on the top surface of the bottom layer 203, thereafter depositing a layer of non-magnetic material over the bottom layer 203 to form the top layer 201.

The embodiments provide packages for semiconductor chips having a magnetic shield with isotropic shielding. For example, the magnetic shielding is uniform for various angles of the external magnetic field.

The terms "first", "second", "third", and the like in the description and in the claims, if any, are used for distinguishing between similar elements and not necessarily for describing a particular sequential or chronological order. It is to be understood that the terms so used are interchangeable under appropriate circumstances such that the embodiments of the device described herein are, for example, capable of operation in sequences other than those illustrated or otherwise described herein. The terms "left", "right", "front", "back", "top", "bottom", "over", "under", and the like in the description and in the claims, if any, are used for descriptive purposes and not necessarily for describing permanent relative positions. It is to be understood that the terms so used are interchangeable under appropriate circumstances such that the embodiments of the device described herein are, for example, capable of operation in other orientations than those illustrated or otherwise described herein. Similarly, if a method is described herein as comprising a series of steps, the order of such steps as presented herein is not necessarily the only order in which such steps may be performed, and certain of the stated steps may possibly be omitted and/or certain other steps not described herein may possibly be added to the method. Furthermore, the terms "comprise", "include", "have", and any variations thereof, are intended to cover a non-exclusive inclusion, such that a process, method, article, or device that comprises a list of elements is not necessarily limited to those elements but may include other elements not expressly listed or inherent to such process, method, article, or device.

While several exemplary embodiments have been presented in the above detailed description of the device, it should be appreciated that number of variations exist. It should further be appreciated that the embodiments are only examples, and are not intended to limit the scope, applicability, dimensions, or configuration of the devices in any way. Rather, the above detailed description will provide those skilled in the art with a convenient road map for implementing an exemplary embodiment of the devices, it being understood that various changes may be made in the function and arrangement of elements and method of fabrication described in an exemplary embodiment without departing from the scope of this disclosure as set forth in the appended claims.

In summary, a shield structure for a semiconductor chip is provided, the shield structure comprising a chip mounting region on a base plate and a shell connected to the base plate. The shell is arranged over the base plate to provide a chamber having a volume, and the chip mounting region is arranged within the volume.

In particular, the following embodiments are explicitly disclosed.
Embodiment 1:
   A shield structure for a semiconductor chip comprising:
   a chip mounting region on a base plate; and
   a shell arranged over the base plate to provide a chamber having a volume within which the chip mounting region is arranged. Herein, the shell may be connected to the base plate.
Embodiment 2:
   The shield structure of embodiment 1, wherein the shell comprises a surface having a curved profile.
Embodiment 3:
   The shield structure of embodiment 2, wherein the shell comprises a domed portion.
Embodiment 4:
   The shield structure of embodiment 2, wherein the surface having a curved profile is an outer surface of the shell.
Embodiment 5:
   The shield structure of embodiment 4, wherein the shell further comprises an inner surface having a curved profile.
Embodiment 6:
   The shield structure of embodiment 1, wherein the shell and the base plate are magnetically coupled.
Embodiment 7:
   The shield structure of embodiment 1, wherein the shell comprises a bottom shell surface adjoining an outer shell surface and an inner shell surface, and the bottom shell surface contacts the base plate.
Embodiment 8:
   The shield structure of embodiment 1, further comprising a first via in the base plate and arranged at least partially below the shell.
Embodiment 9:
   The shield structure of embodiment 8, wherein the first via has a portion that directly contacts the shell.
Embodiment 10:
   The shield structure of embodiment 8, further comprising a second via in the base plate and arranged at least partially below the shell.
Embodiment 11:
   The shield structure of embodiment 8, wherein the first via comprises a via plug.
Embodiment 12:
   The shield structure of embodiment 11, wherein the via plug comprises a magnetic material.
Embodiment 13:
   The shield structure of embodiment 1, wherein the chip mounting region is arranged within a central region of the base plate under the shell.
Embodiment 14:
   The shield structure of embodiment 1, wherein the base plate comprises a multi-layer plate.
Embodiment 15:
   The shield structure of embodiment 14, wherein the multi-layer plate includes a top layer over a bottom layer, wherein the top layer comprises a non-magnetic material.
Embodiment 16:
   The shield structure of embodiment 15, wherein the multi-layer plate comprises a via in the top layer.
Embodiment 17:
   A magnetic shield structure for a semiconductor chip comprising:
   a chip mounting region on a base plate; and
   a shell arranged over the base plate to provide a chamber having a volume within which the chip mounting region is arranged, wherein the shell comprises a magnetic material.
Embodiment 18:
   The magnetic shield structure of embodiment 17, wherein the base plate comprises a magnetic material.
Embodiment 19:
   The magnetic shield structure of embodiment 17, wherein the base plate comprises a first via directly contacting a bottom surface of the shell.
Embodiment 20:
   The magnetic shield structure of embodiment 19, wherein the base plate comprises a second via directly contacting a bottom surface of the shell, the second via being spaced from the first via.
Embodiment 21:
   A shield structure for a semiconductor chip comprising:
   a chip mounting region on a base plate; and
   a shell arranged over the base plate to provide a chamber having a volume within which the chip mounting region is arranged, the shell preferably being connected to the base plate.
Embodiment 22:
   The shield structure of embodiment 21, wherein the shell comprises a surface having a curved profile, the shell preferably comprising a domed portion.
Embodiment 23:
   The shield structure of embodiment 22, wherein the surface having a curved profile is an outer surface of the shell, the shell preferably further comprising an inner surface having a curved profile.
Embodiment 24:
   The shield structure of one of embodiments 21 to 23, wherein the shell and the base plate are magnetically coupled.
Embodiment 25:
   The shield structure of one of embodiments 21 to 24, wherein the shell comprises a bottom shell surface adjoining an outer shell surface and an inner shell surface, and the bottom shell surface contacts the base plate.
Embodiment 26:
   The shield structure of one of embodiments 21 to 25, further comprising a first via in the base plate and arranged at least partially below the shell, the first via preferably having a portion that directly contacts the shell.
Embodiment 27:
   The shield structure of embodiment 26, further comprising a second via in the base plate and arranged at least partially below the shell.
Embodiment 28:
   The shield structure of embodiment 26 or 27, wherein the first via comprises a via plug, the via plug preferably comprising a magnetic material.
Embodiment 29:
   The shield structure of one of embodiments 21 to 28, wherein the chip mounting region is arranged within a central region of the base plate under the shell.
Embodiment 30:
   The shield structure of one of embodiments 21 to 29, wherein the base plate comprises a multi-layer plate.
Embodiment 31:
   The shield structure of embodiment 30, wherein the multi-layer plate includes a top layer over a bottom layer, wherein the top layer comprises a non-magnetic material.
Embodiment 32:
   The shield structure of embodiment 31, wherein the multi-layer plate comprises a via in the top layer.
Embodiment 33:
   The shield structure of one of embodiments 21 to 32, wherein the shell comprises a magnetic material. Accordingly, the shield structure may be considered as representing a magnetic shield structure.
Embodiment 34:
   The shield structure of embodiment 33, wherein the base plate comprises a first via directly contacting a bottom surface of the shell, the base plate preferably comprising a second via directly contacting a bottom surface of the shell with the second via being spaced from the first via.
Embodiment 35:
   The shield structure of one of embodiments 21 to 34, wherein the base plate comprises a magnetic material.

## Claims

1. A shield structure for a semiconductor chip comprising:
a chip mounting region on a base plate; and
a shell arranged over the base plate to provide a chamber having a volume within which the chip mounting region is arranged, the shell preferably being connected to the base plate.

2. The shield structure of claim 1, wherein the shell comprises a surface having a curved profile, the shell preferably comprising a domed portion.

3. The shield structure of claim 2, wherein the surface having a curved profile is an outer surface of the shell, the shell preferably further comprising an inner surface having a curved profile.

4. The shield structure of one of claims 1 to 3, wherein the shell and the base plate are magnetically coupled.

5. The shield structure of one of claims 1 to 4, wherein the shell comprises a bottom shell surface adjoining an outer shell surface and an inner shell surface, and the bottom shell surface contacts the base plate.

6. The shield structure of one of claims 1 to 5, further comprising a first via in the base plate and arranged at least partially below the shell, the first via preferably having a portion that directly contacts the shell.

7. The shield structure of claim 6, further comprising a second via in the base plate and arranged at least partially below the shell.

8. The shield structure of claim 6 or 7, wherein the first via comprises a via plug, the via plug preferably comprising a magnetic material.

9. The shield structure of one of claims 1 to 8, wherein the chip mounting region is arranged within a central region of the base plate under the shell.

10. The shield structure of one of claims 1 to 9, wherein the base plate comprises a multi-layer plate.

11. The shield structure of claim 10, wherein the multi-layer plate includes a top layer over a bottom layer, wherein the top layer comprises a non-magnetic material.

12. The shield structure of claim 11, wherein the multi-layer plate comprises a via in the top layer.

13. The shield structure of one of claims 1 to 12, wherein the shell comprises a magnetic material.

14. The shield structure of claim 13, wherein the base plate comprises a first via directly contacting a bottom surface of the shell, the base plate preferably comprising a second via directly contacting a bottom surface of the shell with the second via being spaced from the first via.

15. The shield structure of one of claims 1 to 14, wherein the base plate comprises a magnetic material.
